# EUROPEAN PATENT SPECIFICATION

(11) **EP 4 080 180 B1**
(45) Date of publication and mention of the grant of the patent: **14.08.2024**
(21) Application number: 22168366.7
(22) Date of filing: 14.04.2022
(51) Int. Cl.: G01K 1/14, G01K 1/16, H01R 13/66, B60L 53/16, H01R 13/04, H05K 1/18

(54) **TEMPERATURE MEASURING DEVICE FOR MEASURING THE TEMPERATURE OF A TERMINAL OF AN ELECTRICAL CONNECTOR**
TEMPERATURMESSEINRICHTUNG ZUR MESSUNG DER TEMPERATUR EINES ANSCHLUSSES EINES ELEKTRISCHEN STECKVERBINDERS
DISPOSITIF DE MESURE DE TEMPÉRATURE DESTINÉ À MESURER LA TEMPERATURE D'UNE BROCHE D'UN CONNECTEUR ÉLECTRIQUE

(30) Priority: 19.04.2021 FR 2104062
(43) Date of publication of application: 26.10.2022
(73) Proprietor: Tyco Electronics France SAS, 95300 Pontoise (FR)
(72) Inventor: PAMART, Olivier, Ecouen (FR); CHATELUS, Eric, Bourg La Reine (FR); DUPONT, Bruno, Paris (FR); FERREIRA, Jose, Auvers sur Oise (FR)
(74) Representative: Grünecker Patent- und Rechtsanwälte PartG mbB

(56) References cited:
- US-A1- 2019 293 493

## Description

### Field of invention

The present invention relates to a temperature measuring device for measuring the temperature of a terminal of an electrical connector and comprising a thermally conductive sleeve, and to a thermally conductive sleeve.

### Background of the invention

In the field of electric vehicles, among others, it is necessary to monitor the temperature of certain components to which an electrical voltage is applied, as mentioned in the document US 2019/293493 A1.

This is even more necessary for the fast charging of electric vehicles. Indeed, a high power, up to 200A or more, at voltages above 200V, or even 1000V (i.e. high voltage), are required.

Under high current conditions (especially with values of 200A or more), the vehicle's electrical circuits are more prone to temperature rises. For safety reasons, the temperature of these components should be measured.

The temperature of an electrical component, such as a terminal of an electrical connector in an electric vehicle, is measured by means of a temperature sensor.

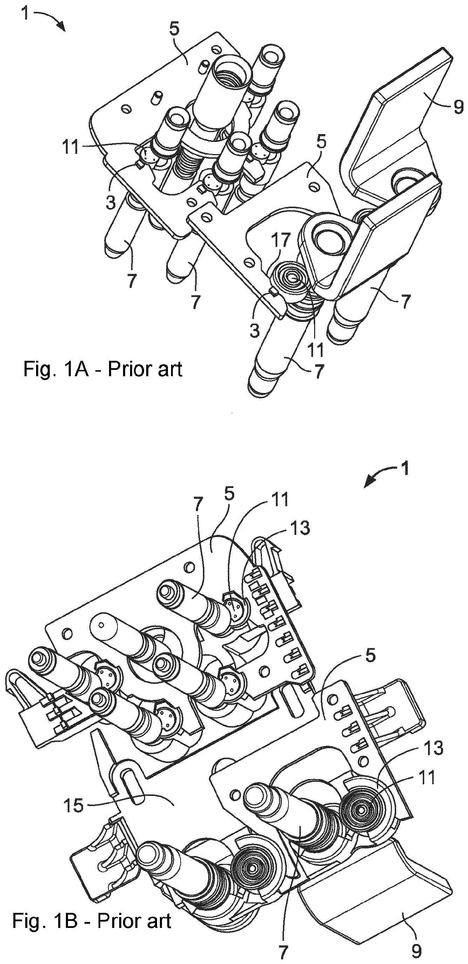

It is known in the prior art, as shown in the assembly 1 illustrated in Figure 1A, to weld or solder temperature sensors 3 to a printed circuit board 5. In order to allow thermal transfer from a terminal 7 of an electrical connector 9 to each temperature sensor 3, a thermally conductive disk 11 is interposed between each terminal 7 and each temperature sensor 3. The thermally conductive disk 11 makes thermal contact with the terminal 7 and with the temperature sensor 3. Thermal transfer from the terminal 7 to the temperature sensor 3 is then made possible via the thermally conductive disk 11. Thus, the temperature sensor 3 is able to measure the temperature of the terminal 7.

However, in order to hold the thermally conductive disks 11 in place, it is necessary to partially accommodate the thermally conductive disks 11 in semicircular-shaped receptacles 13 of a holding piece 15 made of plastic and shown in Figure 1B. The thermally conductive disks 11 are then held by the holding piece 15 and squeezed between the printed circuit board 5 and each terminal 7.

It turns out that during the heat transfer from the terminal 7 to the temperature sensor 3, heat is dissipated in the holding piece 15, which affects the quality and sensitivity of the temperature measurement.

Furthermore, the arrangement shown in Figures 1A and 1B involves the temperature sensor 3 to be mounted sufficiently close to an edge 17 of the printed circuit board 5 so that the temperature sensor 3 can make thermal contact with a thermally conductive disk 11.

However, in high voltage applications, especially above 200V or even 1000V, it is necessary, for safety reasons, to provide a rather long creepage distance between the terminal 7 and the electrical components, such as the temperature sensor 3, of the printed circuit board 5. A creepage distance corresponds to the shortest path between two conductive components across the surface of a printed circuit board. It turns out that the arrangement of the assembly 1 of the prior art is not well-adapted for allowing a suitable creepage distance for high voltage applications.

The object of the present invention is to provide a temperature measuring device which provides a more accurate temperature measurement than is possible in the state of the art, especially in applications with high amperage (especially with values of 200A or more) and high voltages, i.e., above 200V or even 1000V, and which is a simple solution to implement.

### Description of the invention

The object of the present invention is achieved by means of a temperature measuring device for measuring the temperature of a terminal of an electrical connector, according to claim 1.

The term "thermally conductive" characterizes the ability of the sleeve to diffuse heat, i.e. to effect a thermal transfer, without macroscopic displacement of material.

Due to its sleeve shape (which can also be referred to as "sheath"), the thermally conductive sleeve is slid onto a part of the printed circuit board via the recess. The thermally conductive sleeve is then easily held to the printed circuit board without the need for additional holding parts. The thermal transfer takes place without any interfering parts via the flexible tab of the thermally conductive sleeve (which is suitable to be brought into contact with the terminal of the electrical connector) until the first portion of the thermally conductive sleeve, which is in thermal contact with the temperature sensor.

This makes it possible to reduce the heat loss in the heat transfer between the terminal of the electrical connector and the temperature sensor via the thermally conductive sleeve compared to the state of the art.

This results in improved sensitivity and quality of the temperature measurement of the electrical connector terminal.

The flexible tab provides a simple and easy to implement means for contacting the terminal of an electrical connector.

In addition, the sleeve shape increases the creepage distance compared to the known state of the art illustrated in Figures 1A and 1B, because it has a more elongated shape than the thermally conductive disks 11.

The temperature measuring device according to the present invention can be further improved by the following embodiments.

According to one embodiment, a free end of the flexible tab may have a concave shape, in particular a "V" shape, a "U" shape, a semicircular shape or a semi-elliptical shape.

The free end of the flexible tab is intended to be brought into contact with a terminal of an electrical connector.

The geometry of the contour of the free end of the flexible tab can be defined to match the geometry of the terminal and thus further improve the contact of the free end of the tab to a circumference of the electrical connector terminal.

The shape of the free end of the flexible tab, adapted to the shape of the electrical terminal, thereby improves the contact between the terminal of the electrical connector and the free end of the flexible tab.

This results in improved sensitivity and quality of the temperature measurement of the electrical connector terminal.

According to one embodiment, a wall of the first thermally conductive portion may comprise a groove that extends parallel to a depth direction of the recess and a direction of insertion of the thermally conductive sleeve to the part of the printed circuit board, the groove opening into the recess and the temperature sensor being received in the groove.

The temperature sensor is welded or soldered to the printed circuit board. In order to prevent the temperature sensor from being loosened by constraints exerted in the recess by the insertion of the sleeve to the printed circuit board, a through groove is provided in the first portion. This groove allows receiving the temperature sensor, which is thus less mechanically stressed during the insertion of the sleeve because the groove provides it a dedicated housing specifically adapted to its dimensions.

According to the invention, the flexible tab extends in a plane of the printed circuit board from a lateral side of the first thermally conductive portion in an extension direction that is perpendicular to a depth direction of the recess of the first thermally conductive portion.

Such an arrangement saves space in an installation of the temperature measuring device with a terminal of an electrical connector because it allows the length of the thermally conductive sleeve to be reduced compared to an embodiment in which a tab of the same length would extend in a direction parallel to the depth of the recess. Thus, a more compact solution is advantageously obtained.

According to one embodiment, an inner wall delimiting the recess of the first thermally conductive portion of the thermally conductive sleeve may be held by a form-fit connection with the part of the printed circuit board.

Providing a form-fit connection is a simple and easy to implement solution for holding the thermally conductive sleeve to the printed circuit board. Unintentional disengagement of the thermally conductive sleeve from the printed circuit board can thus be avoided.

According to one embodiment, the inner wall may comprise a protrusion that projects toward the recess and the part of the printed circuit board may comprise a corresponding retention means formed by a notch.

The complementarity of a protrusion with a notch makes it possible to obtain easily and simply a connection by form-fit.

According to one embodiment, the first thermally conductive portion of the thermally conductive sleeve may be in frictional connection with the part of the printed circuit board.

Frictional connection (also called frictional contact or frictional engagement), which involves frictional contact, is an interaction that opposes relative movement between the printed circuit board and the thermally conductive sleeve. The latter is thus held by friction (i.e. frictional contact) to the circuit board. It provides a simple and easy implementable retention means.

According to one embodiment, the thermally conductive sleeve can be made of thermally conductive silicone.

The sleeve can thus be a thermally conductive silicone sleeve. Silicone exhibits a very good elastic recovery, superior to that of other elastomers, and is therefore particularly suitable for forming the flexible tab of the sleeve.

Since silicone does not conduct electricity, it can be used as electrical insulation between the terminal of an electrical connector and a conductive component (such as a temperature sensor) on the circuit board to increase the creepage distance.

In addition, silicone has good dielectric properties and high temperature resistance. It is resistant to moisture and has good resistance to aging. This makes it particularly suitable for use in a temperature measuring device in an electric vehicle.

According to one embodiment, the first thermally conductive portion of the thermally conductive sleeve may comprise an open end opening into the recess and a closed end, the closed end being opposite the open end along a depth direction of the recess.

The fact that the sleeve is not configured as a tube (i.e. with two open ends), but comprises a closed end, allows for better heat retention within the sleeve (especially at the closed end) and thus avoids heat losses that would reduce the quality and sensitivity of a temperature measurement.

This also increases the creepage distance from the electrical connector terminal, especially under high voltage, as more of the printed circuit board surface is covered by the thermally conductive silicone sleeve.

According to one embodiment, the temperature sensor may be integrally received within the recess of the first thermally conductive portion of the thermally conductive sleeve.

When the temperature sensor is integrally received in the first portion of the thermally conductive silicone sleeve, it is made possible to increase the creepage distance because more surface area of the circuit board is covered by the thermally conductive silicone sleeve.

In addition, it is protected from the environment, e.g. from dust or other pollution, by the thermally conductive sleeve.

According to an embodiment not covered by the subject-matter of the claims, a thermally conductive sleeve configured for a temperature measuring device as described above for measuring the temperature of a terminal of an electrical connector, is provided and comprises a first thermally conductive portion with a recess through which a part of a printed circuit board of the temperature measuring device can be slid. The thermally conductive sleeve further comprises a second thermally conductive portion forming a flexible tab that extends from the first thermally conductive portion to contact the terminal of the electrical connector. The flexible tab extends from a lateral side of the first thermally conductive portion in an extension direction that is perpendicular to a depth direction of the recess of the first thermally conductive portion.

The term thermally conductive characterizes the ability of the sleeve to diffuse heat, i.e. to effect a thermal transfer, without macroscopic displacement of material.

Due to its sleeve shape, the thermally conductive sleeve can be slid over a part of the printed circuit board. This makes it easy to attach the thermally conductive sleeve to a printed circuit board without the need for additional holding parts. Thermal transfer is thus carried out without interfering parts via the flexible tab of the thermally conductive sleeve (suitable for contacting the terminal of the electrical connector) until the first portion of the thermally conductive sleeve that is in thermal contact with a temperature sensor.

This makes it possible to reduce the heat loss in the heat transfer between the terminal of the electrical connector and the temperature sensor via the thermally conductive sleeve compared to the state of the art.

This results in improved sensitivity and quality of the temperature measurement of the electrical connector terminal.

The flexible tab provides a simple and easy to implement means for contacting the terminal of an electrical connector.

The arrangement of the flexible tab with respect to the lateral side of the first thermally conductive portion saves space in an installation of the temperature measuring device with a terminal of an electrical connector because it allows the length of the thermally conductive sleeve to be reduced compared to an embodiment in which a flexible tab of the same length would extend in a direction parallel to the depth of the recess. Thus, a more compact solution is advantageously obtained.

The invention and its advantages will be further explained in the following by means of preferred embodiments and with particular reference to the following accompanying figures, wherein:
Fig. 1A depicts an assembly comprising a terminal of an electrical connector and a temperature measuring device according to the state of the art.
Fig. 1B depicts the prior art assembly shown in Fig. 1A and a holding piece according to the state of the art.
Fig. 2 represents a temperature measuring device according to a first embodiment of the invention.
Fig. 3 represents a three-dimensional view of the thermally conductive sleeve according to the first embodiment of the invention.
Fig. 4A represents a top view of the thermally conductive sleeve according to the first embodiment of the invention.
Fig. 4B represents a top view of a thermally conductive sleeve according to a second embodiment of the invention.
Fig. 4C represents a top view of a thermally conductive sleeve according to a third embodiment of the invention.
Fig. 4D represents a top view of a thermally conductive sleeve according to a fourth embodiment of the invention.
Fig. 5 represents a temperature measuring device comprising a thermally conductive sleeve according to a fifth embodiment of the invention.
Fig. 6 represents a cross-sectional view of a temperature measuring device according to a sixth embodiment of the invention.
Fig. 7 represents a three-dimensional view of an assembly comprising a terminal of an electrical connector and the temperature measuring device according to the first embodiment of the invention.
Figure 8 shows a cross-sectional and top view of the assembly shown in Figure 7.
Fig. 9 represents a temperature measuring device according to a seventh embodiment not covered by the subject-matter of the claims.
Fig. 10 represents a three-dimensional view of the thermally conductive sleeve according to the seventh embodiment, which is not covered by the subject-matter of the claims.
Fig. 11 represents a cross-sectional view of an assembly comprising a terminal of an electrical connector and the temperature measuring device according to the seventh embodiment, which is not covered by the subject-matter of the claims.

The invention will now be described in more detail using advantageous embodiments in an exemplary manner and with reference to the figures. The embodiments described are merely possible configurations and it should be kept in mind that individual features as described above may be provided independently of each other or may be omitted altogether when implementing the present invention.

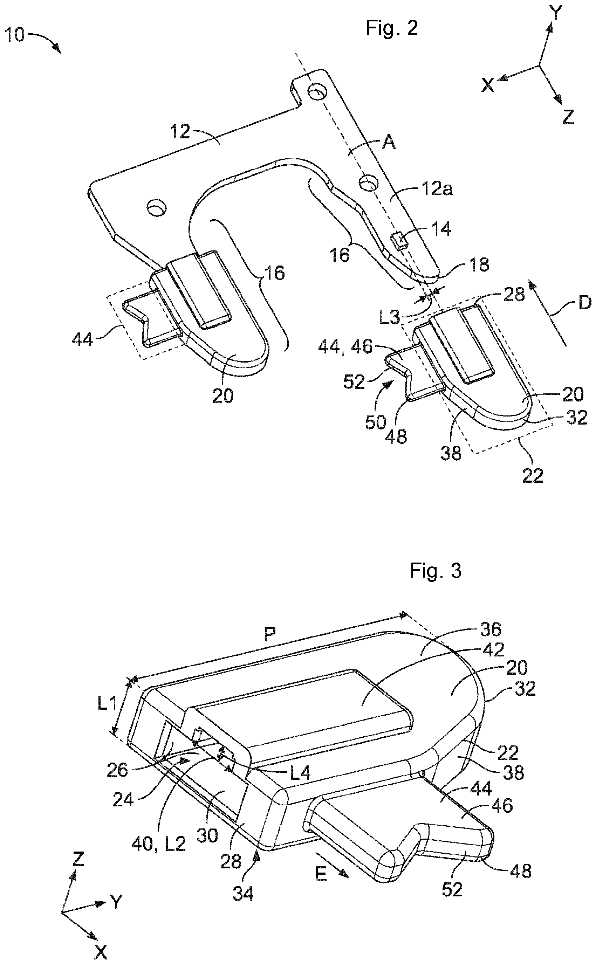

Figure 2 illustrates a temperature measuring device 10 according to a first embodiment of the invention. Such a temperature measuring device 10 is intended to measure the temperature of a conductive component, in particular of a terminal of an electrical connector.

The temperature measurement device 10 comprises a printed circuit board (PCB) 12 having at least one temperature sensor 14 mounted thereon (only one temperature sensor 14 is visible in Figure 2). The temperature sensor 14 is mounted on a face 12a of the PCB 12. In one embodiment (not shown), the temperature sensor 14 may be mounted on a face geometrically opposite the face 12a.

In particular, the temperature sensor 14 is welded or soldered to a part 16 of the PCB 12 that has an elongated shape extending along a longitudinal axis A. The part 16 shown in Figure 2 has an oblong shape along the longitudinal axis A. The part 16 terminates along the longitudinal axis A with a free end 18 that has a curved contour in the plane of the circuit board 12. The plane of the circuit board 12 is parallel to the plane (XY) in the illustration in Figure 2.

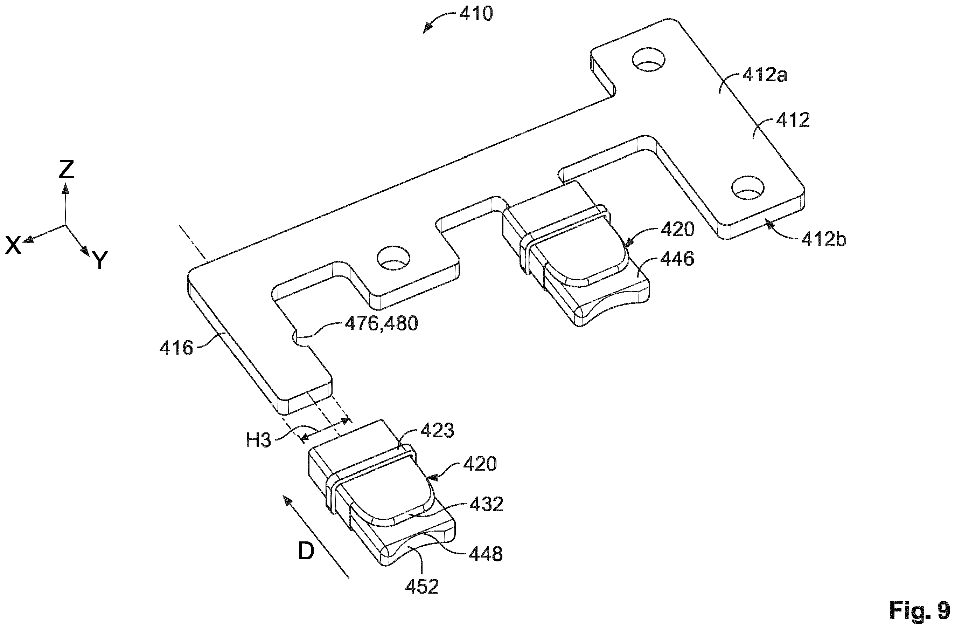

In another embodiment, like the embodiment shown in Figure 9 and described in more detail below, the part 16 may have a rectangular shape along the longitudinal axis A.

According to the present invention, the temperature measuring device 10 comprises a thermally conductive sleeve 20. The term "thermally conductive" means that the sleeve 20 is capable of diffusing heat, in other words, of effecting heat transfer, without macroscopic displacement of material.

According to the first embodiment, the sleeve 20 is a thermally conductive silicone sleeve 20, i.e., it is able to transfer heat but does not conduct electricity. It can thus serve as an electrical insulator. The thermally conductive silicone sleeve 20 is integrally formed, for example by molding.

Figure 2 illustrates on the right a thermally conductive sleeve 20 in position to be slid, i.e. to be slidably engaged, to the part 16 of the printed circuit board 12 along an insertion direction D.

On the left side of Figure 2, the other thermally conductive sleeve 20 is already slid over a part 16 of the printed circuit board 12 so that the temperature sensor 14 (not visible) is in thermal contact with the thermally conductive sleeve 20. Said thermally conductive sleeve 20 is then in frictional engagement with the part 16 of the printed circuit board 12, thereby frictionally retaining the thermally conductive sleeve 20 to the printed circuit board 12.

The thermally conductive sleeve 20 according to the first embodiment is further described in the following with reference to Figure 2 as well as with reference to Figure 3, which depicts a three-dimensional view of the thermally conductive sleeve 20 providing more detail.

The thermally conductive sleeve 20 comprises a first thermally conductive portion 22, shown in Figures 2 and 3 and highlighted by a dotted box in Figure 2.

The first thermally conductive portion 22 comprises a recess 24 (visible in Figure 3) into which the part 16 of the circuit board 12 can be slid. The dimensions of the recess 24 are thus adapted to the dimensions of the part 16 and the height of the temperature sensor 14.

The recess 24 is delimited by an inner wall 26 of the first thermally conductive portion 22. The recess 24 extends in depth along a depth direction P from a first end 28 of the first thermally conductive portion 22. The first end 28 of the first thermally conductive portion 22 thereby comprises an opening 30 that is opened into the recess 24.

The depth of the recess 24 is indicated by the letter "P" in Figure 3. The depth P of the recess 24 extends from the first end 28 in a direction parallel to the Y-axis of the Cartesian coordinate system shown in Figure 3. The depth P of the recess 24 is parallel to the insertion direction D (shown in Figure 2).

The first thermally conductive portion 22 can thus be slid along the insertion direction D on the part 16 of the printed circuit board 12 over a length corresponding to the depth P of the recess 24. The length of the depth P can be defined, in particular increased, in order to improve the retention of the thermally conductive sleeve 20 or/and for increasing the creepage distance (by increasing the distance covered by the thermally conductive sleeve 20).

As explained above with reference to the thermally conductive sleeve 20 shown on the left side of Figure 2, once the thermally conductive sleeve 20 is engaged (by sliding along the direction of insertion D) to the printed circuit board 12, there is a frictional contact, or frictional engagement, between a surface of the PCB's part 16 and the inner wall 26 of the recess 24 of the first thermally conductive portion 22. This frictional contact creates a frictional connection that serves to retain the thermally conductive sleeve 20 to the part 16 of the printed circuit board 12.

The first thermally conductive portion 22 comprises a second end 32 opposite the first end 28 along the depth direction P (i.e. along the Y-axis of the Cartesian coordinate system shown in Figure 3).

In the first embodiment, the second end 32 is a closed end 32, i.e. an end without an opening. The second closed end 32 allow reducing heat losses and thus improves heat transfer. The second closed end 32 can also serve as a indicator for an operator when mounting the thermally conductive sleeve 20 to the printed circuit board 12 because it provides a stop, like an abutment, which indicates to the operator that the thermally conductive sleeve 20 has been sufficiently slid over the part 16.

The second closed end 32 implies that the recess 24 comprises a closed end (not visible in Figures 2 and 3) opposite the opening 30 along the depth P of the recess 24. Once the thermally conductive sleeve 20 is slid into a final position, as shown on the left of Figure 2, the end 18 abuts against the inner wall 26 at said closed end 32 of the recess 24.

In a plane (XY) as shown in Figure 3, the first thermally conductive portion 22 according to the first embodiment has a substantially rectangular shape at the first end 28 and a convex shape at the second end 32. In one embodiment the second end 32 may have a substantially rectangular shape.

The first thermally conductive portion 22 is substantially flat with a thickness L1 between two geometrically opposed walls 34, 36 that each extend in planes (XY) parallel to each other, as shown in Figure 3. When the thermally conductive sleeve 20 is mounted on the PCB 12, as shown at left in Figure 2, the walls 34, 36 extend in planes parallel to the plane (XY) in which the PCB 12 and its part 16 extend. The two opposing walls 34, 36 of the first thermally conductive portion 22 are joined together by a lateral side 38.

According to the first embodiment, the wall 36 of the first thermally conductive portion 22 comprises a groove 40 of width L2 (see Figure 3). The groove 40 extends longitudinally along the depth direction P of the recess 24. The groove 40 extends in a direction parallel to the insertion direction D.

The groove 40 opens into the recess 24. The width L2 (see Figure 3) of the groove 40 is adapted to the width L3 (see Figure 2) of the temperature sensor 14. Thus, the temperature sensor 14 can be received in the groove 40 of the thermally conductive sleeve 20 along the insertion direction D.

The groove 40 allows receiving the temperature sensor 14: the groove 40 provides a dedicated housing specifically adapted to its dimensions. The temperature sensor 14 is thus less mechanically stressed when the thermo-conductive sleeve 20 is inserted along the insertion direction D to the printed circuit board 12.

According to the first embodiment, a bottom 42 of the groove is 40 formed by the wall 36. The groove 40 has a height L4 (see Figure 3) which corresponds to the height (not shown) of the temperature sensor 14. Thus, according to the first embodiment, the temperature sensor 14 is integrally received in the first thermally conductive portion 22 of the thermally conductive sleeve 20. This not only protects the temperature sensor 14 from the surrounding environment, but also further improves the thermal contact between the temperature sensor 14 and the thermally conductive sleeve 20.

According to the present invention, the thermally conductive sleeve 20 further comprises a second thermally conductive portion 44 indicated in Figures 2 and 3 and highlighted by a dotted box in Figure 2.

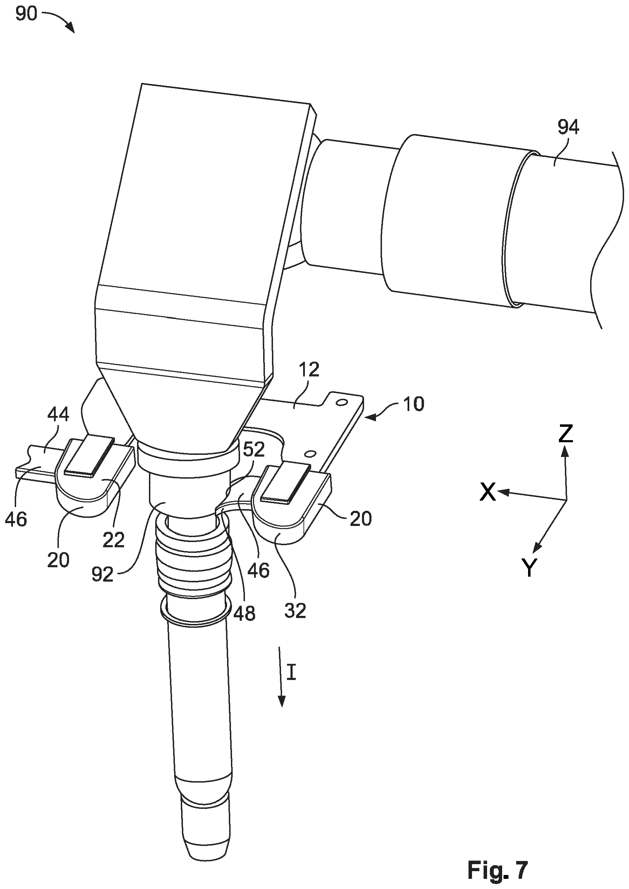

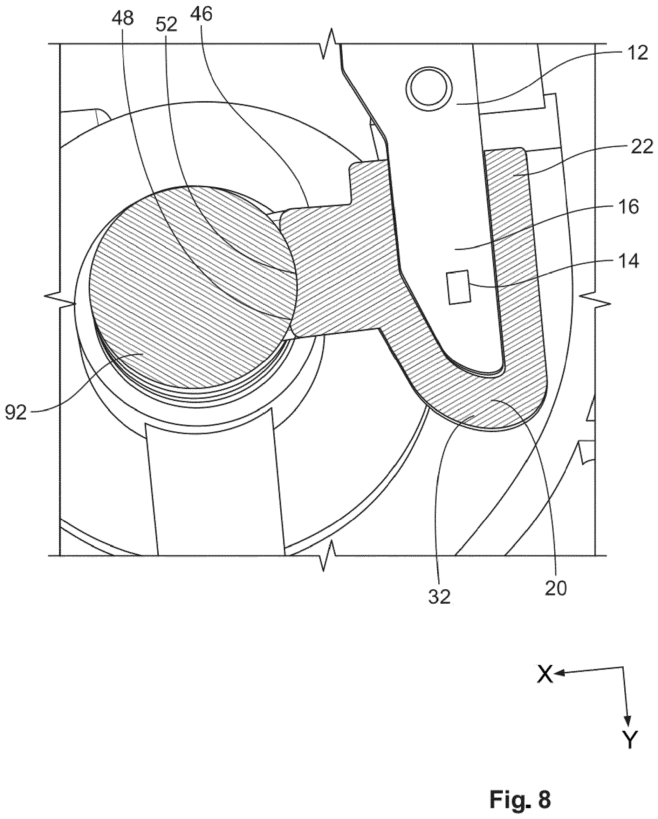

The second thermally conductive portion 44 forms a flexible thermally conductive tab 46 that extends in an extension direction E from the first portion 22 for contacting a terminal of an electrical connector (shown in Figures 7 and 8).

The flexible tab 46, which has a substantially flat shape, extends in an extension plane. The plane of extension corresponds to the plane of extension (XY) in the embodiment of Figures 2 and 3. When the thermally conductive sleeve 20 is mounted on the circuit board 12, as shown in the left side of Figure 2, the plane of extension of the flexible tab 46 is parallel to the plane (XY) in which the circuit board 12 and its part 16 extends. Because the tab 46 is flexible, it can be flexed, bent, and folded. Thus, the flexible tab 46 is flexible.

According to the first embodiment, the flexible tab 46 extends from the lateral side 38 of the first thermally conductive portion 22 until a free end 48 of the flexible tab 46. The extension direction E according to the invention is perpendicular to the depth direction P of the recess 24 of the first thermally conductive portion 22 of the thermally conductive sleeve 20.

In another embodiment not covered by the subject-matter of the claims (the one shown in Figures 9 to 11), the flexible tab 46 extends from the second end 32 of the first thermally conductive portion 22.

In another embodiment (not shown), at least two flexible tabs 46 extend from the first thermally conductive portion 22.

The flexible tab 46 may have a substantially rectangular shape. In this case, a contour of the free end 48 of the flexible tab 46 would be substantially straight in the plane of extension (this embodiment is not shown).

Since it is the contour of the free end 48 of the flexible tab 46 that is intended to contact a terminal of an electrical connector (as explained below with reference to Figures 7 and 8), the geometry of the contour of the free end 48 can advantageously be made to match the shape (especially the circumference) and diameter of the connector terminal. The shape of the free end 48 thus depends on the shape of the electrical connector terminal of which the measuring device 10 is intended to determine the temperature.

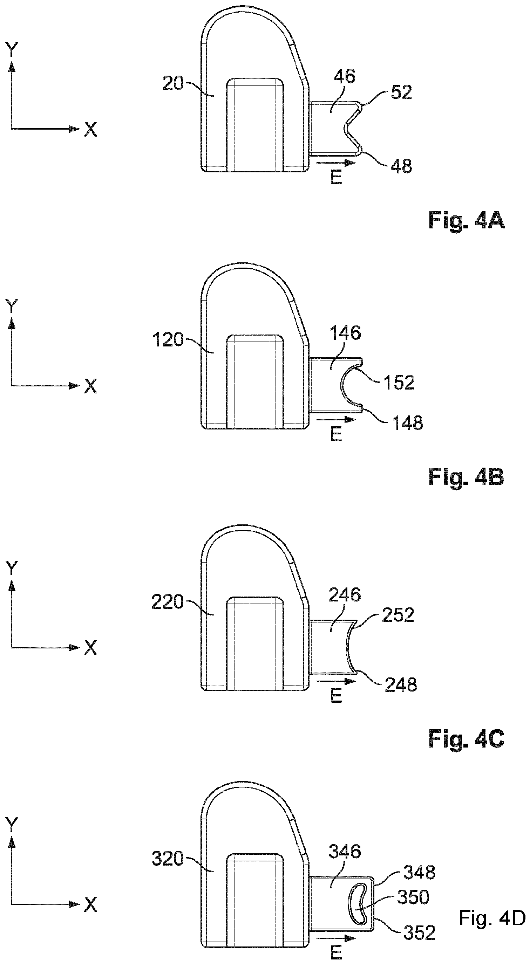

Various examples of the contour geometry of the free end 48 of the flexible tab 46 are shown in Figures 4A to 4D in the plane of extension, i.e. according to a top view of the flexible tab 46 in the plane (XY).

In each of these examples, the contour of the free end 48 of the flexible tab 46 is substantially concave in shape.

The thermally conductive sleeve 20 according to the first embodiment, shown in Figure 4A, as well as Figures 2 and 3, comprises a flexible tab 46 with a free end 48 that has a "V" shaped contour 52 in the plane of extension (XY).

Figure 4B illustrates a thermally conductive sleeve 100 according to a second embodiment. The thermally conductive sleeve 100 comprises a flexible tab 146 with a free end 148 that has a concave contour 152 of semicircular shape in the plane of extension (XY). The radius of said semicircular shape is intended to be adapted to the radius of a terminal (not shown) of which the measuring device 10 is configured to determine its temperature.

Figure 4C illustrates a thermally conductive sleeve 200 according to a third embodiment. The thermally conductive sleeve 200 comprises a flexible tab 246 with a free end 248 that has a concave contour 252 with a semi-elliptical shape in the extension plane (XY). The dimensions of said semi-elliptical shape are intended to be adapted to the dimensions, in particular the circumference dimensions, of a terminal (not shown) of which the measuring device 10 is configured to determine its temperature.

Figure 4D illustrates a thermally conductive sleeve 300 according to a fourth embodiment. The thermally conductive sleeve 300 comprises a flexible tab 346 provided with a cutout 350 at the free end 348. The cutout 350 does not begin directly from the free end 348 but corresponds to an aperture 350 cut into the flexible tab 346 proximate the free end 348. The shape of the cutout 350 is not limited to the geometry shown in Figure 4D.

In the fourth embodiment, the contour 352 has a straight shape because the free end 348 has a rectangular shape. The presence of the cutout 350 allows the free end 348 to have a concave contour 352 when the free end 348 is bearing against a wall, for example of a terminal of an electrical connector. Indeed, when bearing against a wall of a terminal, the free end 348 is deformed so as to at least partially close the aperture 350. Since the cutout 350 is concave in shape, this generates a concave contour 352 at the free end 348.

The present invention is not limited to the geometries illustrated in Figures 4A to 4D but also relates to any other type of concave contour.

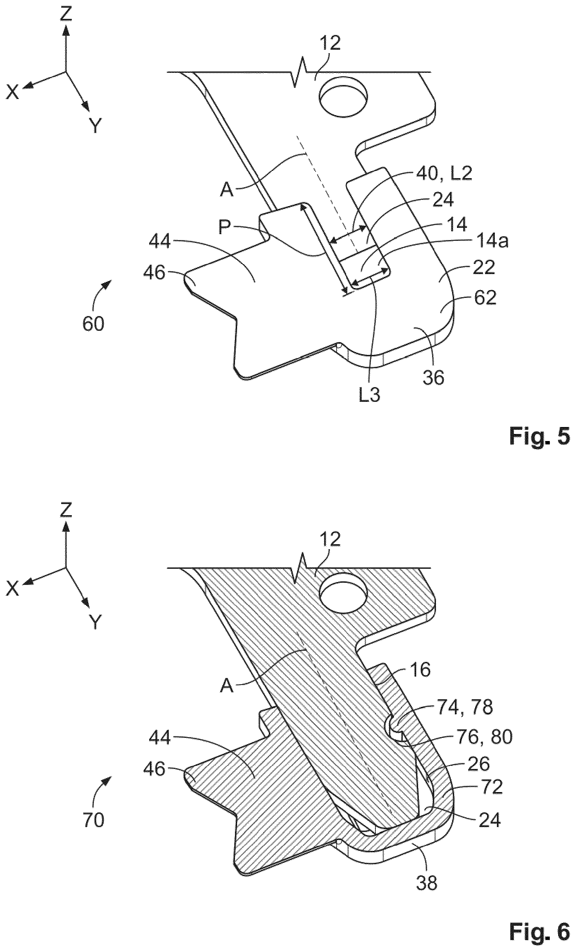

Figure 5 depicts a temperature measurement device 60 comprising a thermally conductive sleeve 62 according to a fifth embodiment of the invention.

The elements with the same numerical references already used for the description of figures 2 and 3 will not be described again in detail, and reference is made to their descriptions above.

The thermally conductive sleeve 62 according to a fifth embodiment of the invention has, like in the first embodiment, a first thermally conductive portion 22 comprising a groove 40 of width L2 that extends longitudinally along the depth direction P of the recess 24. The groove 40 opens into the recess 24. The width L2 of the groove 40 is adapted to the width L3 of the temperature sensor 14. Thus, the temperature sensor 14 can be received in the groove 40 of the thermally conductive sleeve 62.

Unlike the first embodiment, in the fifth embodiment, the wall 36 does not form the bottom of a groove. Accordingly, in the fifth embodiment, the temperature sensor 14 is not integrally received in the first thermally conductive portion 22 of the thermally conductive sleeve 62. A surface 14a of the temperature sensor 14 is thus visible even when the thermally conductive sleeve 62 is slid over the PCB 12, as shown in Figure 5, providing a visual indicator and means of verification.

Figure 6 shows a cross-sectional view in a plane (XY) of a temperature measurement device 70 comprising a thermally conductive sleeve 42 according to a sixth embodiment of the invention.

The elements with the same numerical references already used for the description of figures 2 and 3 will not be described again in detail, and reference is made to their descriptions above.

The thermally conductive sleeve 72 according to a sixth embodiment of the invention comprises an inner wall 26 delimiting the recess 24 of the first thermally conductive portion 22, like in the first embodiment.

According to the sixth embodiment of the invention, the inner wall 26 of the lateral side 38 of the first portion comprises a stop means 74. The stop means 74 is held in a form-fitting manner with a corresponding retention means 76 of the part 16 of the printed circuit board 12, on which the thermally conductive sleeve 72 is inserted.

According to the sixth embodiment of the invention, the stop means 74 is formed by a protrusion 78 that projects toward the recess 24 from the inner wall 26. In the example illustrated in Figure 6, the protrusion 78 has a semi-spherical shape. The corresponding retention means 76 is formed by a notch 80 of complementary shape to the protrusion 78. The notch 80 is formed in the part 16 of the printed circuit board 12. The notch 80 has a semicircular shape in the plane (XY) of the printed circuit board 12.

In another embodiment (not shown), the stop means 74 and the retention means 76 may have a different geometry than shown in Figure 6.

In one embodiment (not shown), the circuit board part 16 may comprise a plurality of retention means 76.

Providing a form-fit connection is a simple and easy implementable solution for retaining the thermally conductive sleeve 72 to the circuit board 12, and unintentional disengagement of the thermally conductive sleeve 72 from the circuit board 12 can be prevented. This is particularly useful for applications in electric vehicles in which the temperature measurement device 70 may be subjected to shock and vibration. The thermally conductive sleeves 20, 120, 220, 320, 62 according to the previously described embodiments may also comprise a stop means 74.

Figure 7 depicts a three-dimensional view of an assembly 90 comprising a terminal 92 of an electrical connector 94 and the temperature measurement device 10 according to the first embodiment of the invention.

Figure 8 shows a cross-sectional and top view of the assembly 90 shown in Figure 7.

Figures 7 and 8 are described together below.

The elements with the same numerical references already used for the description of figures 2 and 3 will not be described again in detail, and reference is made to their descriptions above.

In Figures 7 and 8, and as explained above with reference to Figures 2 and 3, the first thermally conductive portion 22 is in frictional connection with the part 16 of the printed circuit board 12. The thermally conductive sleeve 20 is thus held to the printed circuit board 12 by friction.

On the left side of Figure 7, the thermally conductive sleeve 20 is shown in an initial, so-called unbent state, in which the flexible tab 46 is not bent. In the initial state, the flexible tab 46 extends in the plane of extension that corresponds to the plane (XY) of the printed circuit board 12.

The second thermally conductive portion 44 of the flexible tab 46 is more flexible than the first thermally conductive portion 22, in particular because the first thermally conductive portion 22 receives part (16) of the printed circuit board 12 in its recess (not visible in Figure 7), which gives it more rigidity than the second thermally conductive portion 44.

On the right side of Figure 7, the thermally conductive sleeve 20 is shown in a bent state in which the flexible tab 46 is bent. In the bent state, the flexible tab 46 extends in a curved plane, which is thus not parallel to the plane (XY), the plane (XY) corresponding to the plane of the printed circuit board 12.

Insertion of the terminal 92 along an insertion direction I perpendicular to the printed circuit board 12 and thus to the plane (XY), has the effect of bending the flexible tab 46 of the thermally conductive sleeve 20. Because the tab 46 is flexible and bendable, the operator encounters little resistance when inserting the terminal 92, which facilitates assembly.

The outline 52 of the free end 48 of the flexible tab 46 is in contact with the terminal 92, as shown in Figure 8. Thermal transfer from the terminal 92 to the temperature sensor 14 is thus achieved via the flexible tab 46 and the first thermally conductive portion 22, which is in thermal contact with the temperature sensor 14.

The sleeve shape makes it possible to reduce heat losses during the heat transfer between the terminal 92 of the electrical connector 94 and the temperature sensor 14 via the thermally conductive sleeve 20.

The silicone sleeve shape also allows increasing the creepage distance from the terminal 92 because the sleeve 20 electrically insulates the part 16 of the circuit board 12 covered by the sleeve 20.

Advantageously, the position of the temperature sensor 14 on the printed circuit board 12 is chosen so as to limit the path followed by the thermal transfer in order to improve the sensitivity and quality of the temperature measurement.

The seventh embodiment, described thereafter in reference to the Figures 9 to 11, is not covered by the subject-matter of the claims but is useful for understanding the invention.

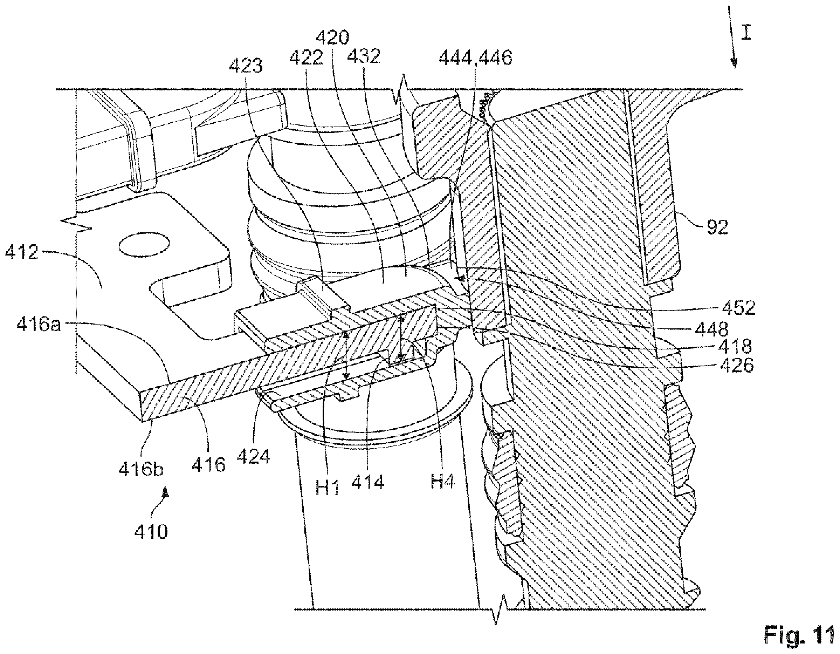

Figure 9 depicts a temperature measuring device 410 according to a seventh embodiment, which is not covered by the subject-matter of the claims. Such a temperature measuring device 410 is intended to measure the temperature of a conductive component, in particular a terminal of an electrical connector, as shown in Figure 11.

The temperature measurement device 410 comprises a PCB 412 having at least one temperature sensor mounted on a side 412b of the circuit board 412. Only one side 412a, geometrically opposite to the side 412b, is visible in Figure 9, so the two temperature sensors (one for each sleeve 420) of the seventh embodiment not covered by the subject-matter of the claims are not visible in the view in Figure 9. A temperature sensor 414 is, however, visible on a face 416b in the cross-sectional view of Figure 11.

More particularly, the temperature sensors are welded or soldered to a portion 416 of the circuit board 412 that has an elongated shape extending along a longitudinal axis A. The portion 416 terminates along the longitudinal axis A with a free end 418. The portion 416 shown in Figure 9 has a rectangular shape along the longitudinal axis A with rounded or chamfered corners at the free end 418.

The plane of the circuit board 412 is parallel to the plane (XY) in the illustration in Figure 9.

As in the sixth embodiment according to the present invention, the portion 416 of the circuit board 412 onto which the thermally conductive sleeve 420 is inserted comprises a retention means 476 formed by a notch 480. The notch 480 has a semicircular shape in the plane (XY) of the circuit board 412. In one embodiment (not shown), the portion 416 of the circuit board 412 may comprise a plurality of retention means 476.

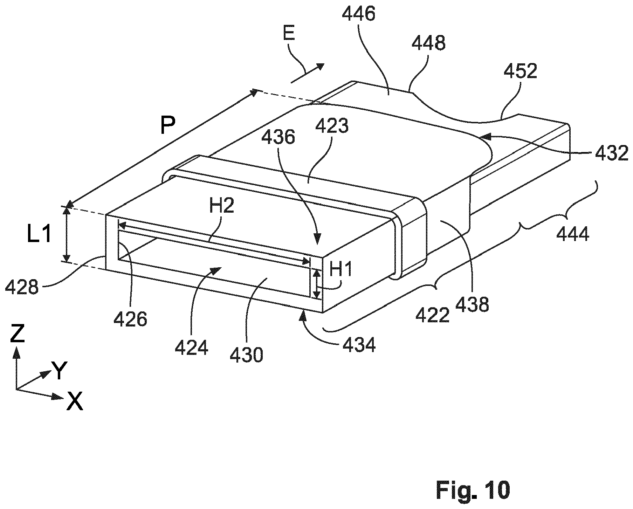

According to the seventh embodiment not covered by the subject-matter of the claims, the temperature measuring device 410 comprises a thermally conductive sleeve 420. It is noted that the two thermally conductive sleeves 420 shown in Figure 9, the thermally conductive sleeve 420 shown in Figure 10, and the thermally conductive sleeve 420 shown in Figure 11, are identical to each other.

In particular, the sleeve 420 is a thermally conductive silicone sleeve, i.e. capable of transferring heat but does not conduct electricity. It can thus serve as an electrical insulator.

Figure 9 illustrates on the left a thermally conductive sleeve 420 in position to be slid, i.e. slidably engaged to the portion 416 of the circuit board 412 along an insertion direction D.

On the right side of Figure 9, the other thermally conductive sleeve 420 is already slid over the part 416 of the PCB 412 so that the temperature sensor (not visible) is in thermal contact with the thermally conductive sleeve 420. Said thermally conductive sleeve 420 is then in frictional engagement with the part 416 of the PCB 412, thereby retaining the thermally conductive sleeve 420 to the circuit board 412.

As in the sixth embodiment according to the invention, the thermally conductive sleeve 420 comprises a stop means, such as a protrusion (not visible), that is retained in a form-fit manner with the corresponding retention means 476 of the portion 416 of the printed circuit board 412 onto which the thermally conductive sleeve 420 is inserted. The form-fit connection prevents unintentional disengagement of the thermally conductive sleeve 420 from the portion 416. This is especially useful for applications in electric vehicles in which the temperature measuring device 410 may be subjected to shock and vibration.

The thermally conductive sleeve 420 according to the seventh embodiment, not covered by the subject-matter of the claims, is further described in the following with reference to figure 9 as well as with reference to figure 10, which depicts a three-dimensional view of the thermally conductive sleeve 420 providing more detail.

The thermally conductive sleeve 420 comprises a first thermally conductive portion 422 and a second thermally conductive portion 444, shown in Figure 10 only.

The first thermally conductive portion 422, as in the first embodiment according to the invention, comprises a recess 424 (visible in Figure 10 only) into which part 416 of the circuit board 412 can be slid. The dimensions of the recess 424 are thus adapted to the dimensions of the portion 416 and the height of the temperature sensor (a temperature sensor 414 is visible in the cross-sectional view in Figure 11).

The recess 424 is delimited by an inner wall 426 of the first thermally conductive portion 422. The recess 424 extends in depth along a depth direction P from a first end 428 of the first thermally conductive portion 422. The first end 428 of the first thermally conductive portion 422 thereby comprises an opening 430 that is opened into the recess 424. According to the seventh embodiment not covered by the subject-matter of the claims, the opening 430 is rectangular.

The depth of the recess 424 is indicated by the letter "P" in Figure 10. The depth P of the recess 424 extends from the first end 428 in a direction parallel to the Y-axis of the Cartesian coordinate system shown in Figure 10. The depth P of the recess 424 is parallel to the insertion direction D (shown in Figure 9).

The first thermally conductive portion 422 can thus be slid along the insertion direction D on the part 416 of the printed circuit board 412 over a length corresponding to the depth P of the recess 424. The length of the depth P may be defined, in particular increased, in order to improve the retention of the thermally conductive sleeve 420 or/and for increasing the creepage distance (by increasing the distance covered by the thermally conductive silicone insulating sleeve 420).

As explained above with reference to the thermally conductive sleeve 420 shown on the right side of Figure 9, once the thermally conductive sleeve 420 is engaged (by sliding along the insertion direction D) to the printed circuit board 412, there is a frictional contact, or frictional engagement, between a surface 416a, 416b of the printed circuit board portion 416 and the inner wall 426 of the recess 424 of the first thermally conductive portion 422. This frictional contact creates a frictional connection that retains the thermally conductive sleeve 420 to the part 416 of the circuit board portion 412.

The first thermally conductive portion 422 comprises a second end 432 opposite the first end 428 along the depth direction P (i.e. along the Y-axis of the Cartesian coordinate system shown in the figure 10).

In the first embodiment according to the invention, the second end 432 is a closed end 432, i.e. an end without an opening. The second closed end 432 reduces heat loss and thus improves heat transfer. The second closed end 432 can also serve as a indicator for an operator when mounting the thermally conductive sleeve 420 to the circuit board 412 because it provides a stop, like an abutment, which indicates to the operator that the thermally conductive sleeve 420 has been sufficiently slid onto the part 416.

The second closed end 432 implies that the recess 424 comprises a closed end (visible in the cross-sectional view of Figure 11) opposite the opening 430 along the depth P of the recess 424. Once the thermally conductive sleeve 420 is slid into a final position, as illustrated by the cross-sectional view of Figure 11, the free end 418 abuts against the inner wall 426 at said closed end of the recess 424.

In a plane (XY) as shown in Figure 10, the first thermally conductive portion 422 has a substantially rectangular shape at the first end 428 and a convex shape at the second end 432. In a variant, the second end 432 may have a substantially rectangular shape.

The first thermally conductive portion 422 is substantially flat with a thickness L1 between two geometrically opposed walls 434, 436 that each extend in planes (XY) parallel to each other as shown in Figure 10. When the thermally conductive sleeve 420 is mounted on the PCB 412, as shown on the right side of Figure 9, the walls 434, 436 extend in planes parallel to the plane (XY) in which the PCB 412 and its portion 416 extend. The two opposing walls 434, 436 of the first thermally conductive portion 422 are joined together by a lateral side 438.

According to the seventh embodiment not covered by the subject-matter of the claims, and unlike the first embodiment and the fifth embodiment according to the present invention, the wall 436 of the first thermally conductive portion 422 does not comprise a longitudinal groove.

Thus, in the seventh embodiment not covered by the subject-matter of the claims, the recess 424 has a rectangular cross-section with a width H1 and a length H2 (see Figure 10). The width H1 corresponds to the overall height H4 (only visible in the cross-sectional view of Figure 11) of the portion 416 and the temperature sensor 414 welded or soldered to the PCB 412. The length H2 corresponds to the width H3 (see Figure 9) of the part 416 of the circuit board 412.

According to the seventh embodiment not covered by the subject-matter of the claims, and unlike the first embodiment and the fifth embodiment according to the present invention, the first portion 422 is provided with a collar 423, formed by a shoulder 423 projecting from an outer wall (comprising the walls 434, 436, 438) of the first portion 422 around the outer circumference of the first portion 422. The collar 423 serves to mechanically reinforce the first portion 422 and provide a means for an operator to grip the thermally conductive sleeve 420 to the circuit board 412.

According to the seventh embodiment not covered by the subject-matter of the claims, and as in the first embodiment according to the present invention, the temperature sensor 414 is integrally received within the first thermally conductive portion 422 of the thermally conductive sleeve 420 (see Figure 11). This not only protects the temperature sensor from the environment, but also further improves the thermal contact between the temperature sensor 414 and the thermally conductive sleeve 420.

According to the seventh embodiment not covered by the subject-matter of the claims, the thermally conductive sleeve 420 further comprises a second thermally conductive portion 444, shown in Figure 10.

The second thermally conductive portion 444 forms a flexible thermally conductive tab 446 that extends along an extension direction E from the first portion 422 to contact a terminal of an electrical connector (shown in Figures 7 and 8).

The flexible tab 446, which has a substantially flat shape, extends in an extension plane. Said extension plane corresponds to the plane of extension (XY) in the seventh embodiment not covered by the subject-matter of the claims of Figures 9 and 10. When the thermally conductive sleeve 420 is mounted on the circuit board 412, as shown on the right side of Figure 9, the extension plane of the flexible tab 446 is parallel to the plane (XY) in which the circuit board 412 and its portion 416 extend. Because the flexible tab 446 is flexible, it can be deformed or even bent or folded. Thus, the flexible tab 446 is flexible.

According to the seventh embodiment not covered by the subject-matter of the claims, the flexible tab 446 extends from the closed end 432 of the first thermally conductive portion 422 to a free end 448 of the flexible tab 446. Accordingly, the direction of extension E according to the seventh embodiment not covered by the subject-matter of the claims, unlike the other embodiments according to the invention, is parallel to the depth direction P of the recess 424 of the first thermally conductive portion 422 of the thermally conductive sleeve 420.

The flexible tab 446 may have a substantially rectangular shape. In this case, a contour of the free end 448 of the flexible tab 446 would be substantially straight in the plane of extension (this embodiment is not shown).

Since it is the contour of the free end 448 of the flexible tab 446 that is intended to contact a terminal of an electrical connector (as previously explained with reference to FIGS. 7 and 8), the geometry of the contour of the free end 448 can advantageously be made according to the shape (in particular, the circumference) and diameter of the connector terminal. The shape of the free end 448 thus depends on the shape of the electrical connector terminal of which the measuring device 410 is intended to determine the temperature.

In the seventh embodiment not covered by the subject-matter of the claims, the thermally conductive sleeve 420 comprises a flexible tab 446 with a free end 448 that has a concave semi-elliptical contour 452 in the extension plane (XY).

Figure 11 depicts a cross-sectional view of an assembly comprising a terminal 92 of an electrical connector and the temperature measurement device 410 according to the seventh embodiment not covered by the subject-matter of the claims.

The elements with the same numerical references already used for the description of figures 9 and 10 will not be described again in detail, and reference is made to their descriptions above. The thermally conductive sleeve 420 is shown in cross-section in a bent state in which the flexible tab 446 is bent. In the bent state, the flexible tab 446 extends in a curved plane, which is not parallel to the plane (XY) or to the plane of the printed circuit board 412.

Because the flexible tab 446 according to the seventh embodiment not covered by the subject-matter of the claims is shorter along the direction of extension E than the tab 46 according to the first embodiment according to the present invention, and extends from the closed end 432 (and not from the lateral side 438), the flexible tab 446 is less bent by the insertion of the terminal 92 compared to the first embodiment according to the present invention. Nonetheless, insertion of the terminal 92 along an insertion direction I perpendicular to the circuit board, and thus to the plane (XY), results in the flexible tab 446 of the thermally conductive sleeve 420 being bent. Because the tab 446 is flexible and bendable, the operator encounters little resistance when inserting the terminal 92, which facilitates assembly.

The contour 452 of the free end 448 of the flexible tab 446 is in contact with the terminal 92. A thermal transfer from the terminal 92 to the temperature sensor 414 is thus achieved via the flexible tab 446 and the first thermally conductive portion 422, which is in thermal contact with the temperature sensor 414.

Thanks to the sleeve shape, it is possible to reduce the heat loss during the heat transfer between the terminal 92 of the electrical connector and the temperature sensor 414 via the thermally conductive sleeve 420.

The silicone sleeve shape also allows increasing the creepage distance from the terminal 92 because the sleeve 420 electrically insulates the portion 416 of the PCB 412 covered by the sleeve 420.

Advantageously, the position of the temperature sensor 414 on the printed circuit board 412 is selected so as to limit the path followed by the thermal transfer in order to improve the sensitivity and quality of the temperature measurement.

### List of references

1 : assembly (according to the state of the art)
3: temperature sensor (according to the state of the art)
5: printed circuit board (according to the state of the art)
7: terminal (according to the state of the art)
9 : electrical connector (according to the state of the art)
11 : thermally conductive disc (according to the state of the art)
13: receptacle (according to the state of the art)
15: holding piece (according to the state of the art)
17: edge (according to the state of the art)
10: temperature measurement device according to the first embodiment
12: printed circuit board (PCB)
16: part of the printed circuit board
18 : free end
20: thermally conductive sleeve according to the first embodiment
22 : first thermally conductive portion
24 : recess
26: inner wall
28 : first end
30 : opening
32 : second end
34, 36: opposite walls
38 : lateral side
40 : groove
42 : bottom of the groove
44 : second thermally conductive portion
46, 146, 246, 346: thermally conductive flexible tab
48, 148, 248, 348: free end
52, 152, 252, 352: outline, contour
60: temperature measuring device according to a fifth embodiment
62 : thermally conductive sleeve according to the fifth embodiment
70 : temperature measuring device according to a sixth embodiment
72 : thermally conductive sleeve according to the sixth embodiment
74 : stopping means
76 : retention means
78 : protrusion
80 : notch
90 : assembly
92 : terminal
94 : electrical connector
120 : thermally conductive sleeve according to the second embodiment
220 : thermally conductive sleeve according to the third embodiment
320 : thermally conductive sleeve according to the fourth embodiment
350 : cutout, aperture
410: temperature measuring device according to the seventh embodiment
412: printed circuit board
416: part of the printed circuit board
416a, 416b: opposing surfaces
418 : free end
420 : thermally conductive sleeve according to the seventh embodiment
422 : first thermally conductive portion
423 : collar, shoulder
424 : recess
426: inner wall
428 : first end
430 : opening
432 : second end
434, 436: opposite walls
438 : lateral side
444 : second thermally conductive portion
446 thermally conductive flexible tab
448 : free end
452: outline, contour
476: retention means
480 : notch
A : longitudinal axis
D : insertion direction of the thermally conductive sleeve
I : direction of insertion of the terminal
E : extension direction
H1 : width
H2 : length
H3 : width
H4 : height
L1 : thickness
L2 : slot width
L3: temperature sensor width
L4 : height
P : recess depth
X,Y,Z : coordinates of a Cartesian coordinate system

## Claims

1. A temperature measuring device (10) for measuring the temperature of a terminal of an electrical connector, comprising:
a printed circuit board (12),
a temperature sensor (14) mounted on the printed circuit board (12),
a thermally conductive sleeve (20, 120, 220, 320, 62, 72) comprising a first thermally conductive portion (22) with a recess (24) into which a part (16) of the printed circuit board (12) is slid, the first thermally conductive portion (22) being in thermal contact with the temperature sensor (14), the thermally conductive sleeve (20, 120, 220, 320, 62, 72) further comprising a second thermally conductive portion (44) forming a flexible tab (46, 146, 246, 346) that extends from the first thermally conductive portion (22) for contacting the terminal of the electrical connector,
**characterized in that**:
the flexible tab (46, 146, 246, 346) extends in a plane of the printed circuit board (12) from a lateral side (38) of the first thermally conductive portion (22) in an extension direction (E) that is perpendicular to a depth direction (P) of the recess (24) of the first thermally conductive portion (22).

2. The temperature measuring device (10) of claim 1, wherein a free end (48, 148, 248) of the flexible tab (46, 146, 246) has a concave shape, in particular a "V"-shape, a "U"-shape, a semicircular shape, or a semielliptical shape.

3. The temperature measuring device (10) according to claim 1 or 2, wherein a wall (26) of the first thermally conductive portion (22) comprises a groove (40) that extends parallel to a depth direction (P) of the recess (24) and an insertion direction (D) of the thermally conductive sleeve (20, 120, 220, 320, 62, 72) to the part (16) of the printed circuit board (12), the groove (40) opening into the recess (24) and the temperature sensor (14) being received in the groove (40).

4. The temperature measuring device (10) according to any of the preceding claims, wherein an inner wall (26) delimiting the recess (24) of the first thermally conductive portion (22) of the thermally conductive sleeve (72) is held by a form-fit connection with the part (16) of the printed circuit board (12).

5. The temperature measuring device (10) of claim 4, wherein the inner wall (26) comprises a protrusion (78) which projects towards the recess (24) and the part (16) of the printed circuit board (12) comprises a corresponding retention means (76) formed by a notch (80).

6. The temperature measuring device (10) of any of the preceding claims, wherein the first thermally conductive portion (22) of the thermally conductive sleeve (20, 120, 220, 320, 62, 72) is in frictional connection with the part (16) of the printed circuit board (12).

7. The temperature measuring device (10) according to any of the preceding claims, wherein the thermally conductive sleeve (20, 120, 220, 320, 62, 72) is made of thermally conductive silicone.

8. The temperature measuring device (10) of any of the preceding claims, wherein the first thermally conductive portion (22) of the thermally conductive sleeve (20, 120, 220, 320, 62, 72) comprises an open end (28, 30) opening into the recess (24) and a closed end (32), the closed end (32) being opposite the open end (28, 30) along a depth direction (P) of the recess (24).

9. The temperature measuring device (10) of any of the preceding claims, wherein the temperature sensor (14) is integrally received in the recess (24) of the first thermally conductive portion (22) of the thermally conductive sleeve (20, 120, 220, 320, 72).

## Patentansprüche

1. Temperaturmessvorrichtung (10) zum Messen der Temperatur eines Anschlusses eines elektrischen Steckverbinders, umfassend:
eine gedruckte Leiterplatte (12),
einen Temperatursensor (14), der auf der gedruckten Leiterplatte (12) angebracht ist,
eine wärmeleitende Hülse (20, 120, 220, 320, 62, 72), die einen ersten wärmeleitenden Abschnitt (22) mit einer Aussparung (24) umfasst, in welche ein Teil (16) der gedruckten Leiterplatte eingeschoben wird,
wobei der erste wärmeleitende Abschnitt (22) in thermischem Kontakt mit dem Temperatursensor (14) steht,
wobei die wärmeleitende Hülse (20, 120, 220, 320, 62, 72) außerdem einen zweiten wärmeleitenden Abschnitt (44) umfasst, welcher eine flexible Lasche (46, 146, 246, 346) bildet, welche sich von dem ersten wärmeleitenden Abschnitt (22) aus erstreckt, um den Anschluss des elektrischen Steckverbinders zu kontaktieren,
**dadurch gekennzeichnet, dass**:
die flexible Lasche (46, 146, 246, 346) sich in einer Ebene der gedruckten Leiterplatte (12) von einer seitlichen Seite (38) des ersten wärmeleitenden Abschnitts (22) in einer Erstreckungsrichtung (E) erstreckt, die senkrecht zu einer Tiefenrichtung (P) der Aussparung (24) des ersten wärmeleitenden Abschnitts (22) ist.

2. Temperaturmessvorrichtung (10) nach Anspruch 1, wobei ein freies Ende (48, 148, 248) der flexiblen Lasche (46, 146, 246) eine konkave Form, insbesondere eine "V"-Form, eine "U"-Form, eine halbkreisförmige Form oder eine halbelliptische Form aufweist.

3. Temperaturmessvorrichtung (10) gemäß Anspruch 1 oder 2, wobei eine Wand (26) des ersten wärmeleitenden Abschnitts (22) eine Nut (40) umfasst, die sich parallel zu einer Tiefenrichtung (P) der Aussparung (24) und einer Einschubrichtung (D) der wärmeleitenden Hülse (20, 120, 220, 320, 62, 72) zu dem Teil (16) der gedruckten Leiterplatte (12) erstreckt, wobei sich die Nut (40) in die Aussparung (24) öffnet und der Temperatursensor (14) in der Nut (40) aufgenommen ist.

4. Temperaturmessvorrichtung (10) gemäß einem der vorhergehenden Ansprüche, wobei eine die Aussparung (24) begrenzende Innenwand (26) des ersten wärmeleitenden Abschnitts (22) der wärmeleitenden Hülse (72) durch eine formschlüssige Verbindung mit dem Teil (16) der gedruckten Leiterplatte (12) gehalten wird.

5. Temperaturmessvorrichtung (10) nach Anspruch 4, wobei die Innenwand (26) einen Vorsprung (78) umfasst, welcher in Richtung der Aussparung (24) vorragt, und das Teil (16) der gedruckten Leiterplatte (12) ein entsprechendes Rückhaltemittel (76), das durch eine Einkerbung (80) gebildet wird, umfasst.

6. Temperaturmessvorrichtung (10) nach einem der vorhergehenden Ansprüche, wobei der erste wärmeleitende Abschnitt (22) der wärmeleitenden Hülse (20, 120, 220, 320, 62, 72) in einer kraftschlüssigen Verbindung mit dem Teil (16) der gedruckten Leiterplatte (12) steht.

7. Temperaturmessvorrichtung (10) gemäß einem der vorhergehenden Ansprüche, wobei die wärmeleitende Hülse (20, 120, 220, 320, 62, 72) aus wärmeleitendem Silikon hergestellt ist.

8. Temperaturmessvorrichtung (10) nach einem der vorhergehenden Ansprüche, wobei der erste wärmeleitende Abschnitt (22) der wärmeleitenden Hülse (20, 120, 220, 320, 62, 72) ein offenes Ende (28, 30), das sich in die Aussparung (24) öffnet, und ein geschlossenes Ende (32) umfasst, wobei das geschlossene Ende (32) gegenüber dem offenen Ende (28, 30) entlang einer Tiefenrichtung (P) der Aussparung (24) liegt.

9. Temperaturmessvorrichtung (10) nach einem der vorhergehenden Ansprüche, wobei der Temperatursensor (14) ganzheitlich in der Aussparung (24) des ersten wärmeleitenden Abschnitts (22) der wärmeleitenden Hülse (20, 120, 220, 320, 72) aufgenommen ist.

## Revendications

1. Dispositif de mesure de température (10) pour mesurer la température d'une borne d'un connecteur électrique, comprenant :
une carte de circuit imprimé (12),
un capteur de température (14) monté sur la carte de circuit imprimé (12),
un manchon thermiquement conducteur (20, 120, 220, 320, 62, 72) comprenant une première partie thermiquement conductrice (22) avec un évidement (24) dans lequel est glissée une partie (16) de la carte de circuit imprimé (12),
la première partie thermiquement conductrice (22) étant en contact thermique avec le capteur de température (14),
le manchon thermiquement conducteur (20, 120, 220, 320, 62, 72) comprenant en outre une deuxième partie thermiquement conductrice (44) formant une languette flexible (46, 146, 246, 346) qui s'étend depuis la première partie thermiquement conductrice (22) pour entrer en contact avec la borne du connecteur électrique,
**caractérisé en ce que** :
la languette flexible (46, 146, 246, 346) s'étend dans un plan de la carte de circuit imprimé (12) depuis un côté latéral (38) de la première partie thermiquement conductrice (22) dans une direction d'extension (E) qui est perpendiculaire à une direction de profondeur (P) de l'évidement (24) de la première partie thermiquement conductrice (22).

2. Dispositif de mesure de température (10) de la revendication 1, dans lequel une extrémité libre (48, 148, 248) de la languette flexible (46, 146, 246) présente une forme concave, notamment une forme en « V », une forme en « U », une forme semi-circulaire ou une forme semi-elliptique.

3. Dispositif de mesure de température (10) de la revendication 1 ou 2, dans lequel une paroi (26) de la première partie thermiquement conductrice (22) comprend une rainure (40) qui s'étend parallèlement à une direction de profondeur (P) de l'évidement (24) et à une direction d'insertion (D) du manchon thermiquement conducteur (20, 120, 220, 320, 62, 72) dans la partie (16) de la carte de circuit imprimé (12), la rainure (40) s'ouvrant dans l'évidement (24) et le capteur de température (14) étant reçu dans la rainure (40).

4. Dispositif de mesure de température (10) de l'une des revendications précédentes, dans lequel une paroi interne (26) délimitant l'évidement (24) de la première partie thermiquement conductrice (22) du manchon thermiquement conducteur (72) est maintenue par une liaison par ajustement de forme avec la partie (16) de la carte de circuit imprimé (12).

5. Dispositif de mesure de température (10) de la revendication 4, dans lequel la paroi interne (26) comprend une saillie (78) qui fait saillie vers l'évidement (24) et la partie (16) de la carte de circuit imprimé (12) comprend un moyen de retenue correspondant (76) formé par une encoche (80).

6. Dispositif de mesure de température (10) de l'une des revendications précédentes, dans lequel la première partie thermiquement conductrice (22) du manchon thermiquement conducteur (20, 120, 220, 320, 62, 72) est en liaison par friction avec la partie (16) de la carte de circuit imprimé (12).

7. Dispositif de mesure de température (10) selon l'une des revendications précédentes, dans lequel le manchon thermiquement conducteur (20, 120, 220, 320, 62, 72) est réalisé en silicone thermiquement conducteur.

8. Dispositif de mesure de température (10) de l'une des revendications précédentes, dans lequel la première partie thermiquement conductrice (22) du manchon thermiquement conducteur (20, 120, 220, 320, 62, 72) comprend une extrémité ouverte (28, 30) s'ouvrant dans l'évidement (24) et une extrémité fermée (32), l'extrémité fermée (32) étant opposée à l'extrémité ouverte (28, 30) le long d'une direction de profondeur (P) de l'évidement (24).

9. Dispositif de mesure de température (10) de l'une des revendications précédentes, dans lequel le capteur de température (14) est reçu d'un seul tenant dans l'évidement (24) de la première partie thermiquement conductrice (22) du manchon thermiquement conducteur (20, 120, 220, 320, 72).
